# EUROPEAN PATENT APPLICATION

(11) **EP 2 068 376 A1**
(43) Date of publication of application: **10.06.2009**
(21) Application number: 06775381.4
(22) Date of filing: 14.08.2006
(51) Int. Cl.: H01L 31/068, H01L 31/18

(54) **A SOLAR CELL OF QUANTUM WELL STORE**

(71) Applicant: Jiangsu Sunshine Solar Electric Power Co., Ltd, Jiangsu 214426 (CN)
(72) Inventor: CHEN, Zhongmou, Jiangsu 210036 (CN)
(74) Representative: Vossius & Partner
(86) International application number: PCT/CN2006/002063
(87) International publication number: WO 2008/031250

(57) **Abstract**

A solar cell of quantum well store is disclosed, including a semiconductor substrate (1), a diffusion layer (2) and upper and lower electrodes (7,6), a light doped epitaxial layer (10) whose conductive type is the same as the semiconductor substrate is disposed on the semiconductor substrate (1), there are ribs on the epitaxial layer (10), the ribs are the structure of strip shape and comprise multiple perpendicular ribs (11) which are parallel and at least a longitudinal rib (13), the longitudinal rib (13) is connected with and runned through perpendicular ribs(11), a interspace surrounded by longitudinal rib (13) and perpendicular ribs (11) is a space of ribs (12); disposed on the ribs of strip shape: a nanometer ion-implanted layer (3) which has opposite conductive type to that of epitaxial layer and a high doped layer (4) which has opposite conductive type to that of ion-implanted layer, the ion-implanted layer is covered with the high doped layer, and the high doped layer is covered with a metal layer (9); the lead of upper electrode (7) is connected to the metal layer on the longitudinal rib; the diffusion layer (2) is disposed in the space of ribs and its conductive type is opposite with that of epitaxial layer, a oxide layer (5) is disposed on the diffusion layer; and, the voltage of back field is applied between the upper and lower electrodes.

## Description

### Technical field

This present invention relates to a type of solar cell, in particular to a type of solar cell of quantum well store and its preparation process.

### Background of the invention

Solar cell is a semiconductor device based on semiconductor material and featuring the function of photovoltaic conversion. The operating principle of solar cell is based on photo-generated Volta effect of semiconductor, which directly converts solar radiation energy to electric energy. Existing solar cells normally consist of PN junction formed by a semiconductor substrate and a diffusion layer, and electrodes led from both ends of this PN junction. By means of the built-in field of PN junction, photo-generated carriers generated under lighting conditions migrate to the two sides of PN junction, resulting in photo-generated current, realizing photovoltaic conversion.

Efficiency of solar cells has been the focus of public attention. Currently, single crystal silicon cell is the solar cell of the highest conversion efficiency. This cell can convert 16%∼20% of incident light to electric current. The reason why only a small percentage of solar light can be converted to electric energy is that the existing solar cells can not convert most of solar light to electric current. Solar light contains a very wide spectrum of electromagnetic wave, i.e. 0.25∼2.2 µm, from infrared light, visible light of various colors, to ultraviolet light. Roughly, ultraviolet light is 7%, visible light is 45%, and infrared light is 47%. For existing silicon cells, to generate electron-hole pairs to form current, only light of wavelength less than 1.1 µm has sufficient energy. In solar spectrum, long wave part of wavelength exceeding 1.1 µm cannot generate electron-hole pair; instead, this part is converted to heat. In solar radiation, about 25% of light energy is such and cannot be utilized. If light energy is sufficient to generate electron-hole pairs, a part of this energy is also converted to heat. As such, 30% of solar energy is not utilized. The two factors described above are main causes of low conversion efficiency of traditional solar cells. Besides, for existing solar cells, even if all incident solar light is converted to electric energy, output power per unit area is still too low, so that if solar energy is to be used as driving power, large area of solar cells is necessary, and would hamper application. For example, solar energy automobile technology is limited by this point and cannot be quickly developed. In existing technologies, no major breakthrough has been made in terms of small area, high output power solar cell structure and preparation.

### Summary of the invention

For problems described above, this invention discloses a solar cell based on new approach, new structure and new process for making it: the solar cell of quantum well store. In addition to photo-voltaic conversion, structure of the new cell can fully absorb "thermal energy carriers" to generate electric current, to form main current of this cell, thereby bringing about a decisive leap of conversion efficiency. This invention also provides preparation process of the new solar cell of quantum well store, to allow large scale industrial production.

In order to solve the above mentioned problem, the present invention provides a solar cell of quantum well store comprising a semiconductor substrate, a diffusion layer and upper and lower electrodes, **characterized in that** a light doped epitaxial layer whose conductive type is the same as the semiconductor substrate is disposed on the semiconductor substrate, there are ribs on the epitaxial layer, wherein the ribs have a structure of strip shape and comprise multiple parallel longitudinal ribs and at least one transverse rib, wherein the transverse rib is connected with and runs through the parallel longitudinal ribs; wherein an interspace is surrounded by longitudinal ribs and transverse rib; wherein disposed on the ribs of strip shape are: a nanometer ion-implanted layer having opposite conductive type to that of epitaxial layer and a high doped layer having opposite conductive type to that of ion-implanted layer, wherein the nanometer ion-implanted layer is covered with the high doped layer, and the high doped layer is covered with a metal layer; wherein the lead of upper electrode is connected to the metal layer on transverse rib; wherein the diffusion layer is disposed in the whole between the ribs and its conductive type is opposite with that of epitaxial layer, an oxide layer is disposed on the diffusion layer; and wherein the voltage of back field is applied between the upper and lower electrodes.

In the above scheme, said parallel, strip shaped longitudinal ribs and transverse rib constitute a grid distribution on the epitaxial layer. Epitaxial layer above ribs is treated by semiconductor process to form nanometer ion-implanted layer, high doped layer, and metal layer. Diffusion layer of said between the ribs is the same as that of traditional solar cell structure. Said transverse rib is basically perpendicular to said longitudinal ribs.

In other words, solar cell of quantum well store of this invention consists of solar cell chip and DC power supply generating back field voltage connected in series. The differences between structure of this invention and that of traditional solar cells are: Epitaxial layer is divided into ribs and between the ribs; and diffusion layer is provided in between the ribs. On the ribs, ion-implanted layer and high doped layer are provided, and the ion-implanted layer is covered by high doped layer. Ion-implanted layer is clamped by epitaxial layer and high doped layer to form a sandwich structure. Conductive type of ion-implanted layer is opposite to that of epitaxial layer and high doped layer. In the sandwich structure, two **PN** junctions are formed. Among ribs of sandwich structure is the diffusion layer, whose conductive type is opposite to that of epitaxial layer and substrate. The sandwich structure on ribs is connected to diffusion layer in between the ribs to form well store, i.e. quantum well store.

In above scheme, said semiconductor substrate material and epitaxial layer jointly constitute semiconductor base layer.

Said semiconductor epitaxial layer can be of **p⁻** type, the diffusion layer of **n⁺** type, ion-implanted layer of **n⁺** type, and high doped layer of **p⁺⁺** type; or

Said semiconductor epitaxial layer can be of **n⁻** type, the diffusion layer of **p⁺** type, ion-implanted layer of **p⁺** type, and high doped layer of **n⁺⁺** type.

In above description, ^{·}; ⁺ and ⁺⁺ indicate doping of semiconductor materials and correspond to light doping, high doping, and extra high doping respectively.

Concentration of said ion-implanted layer is 10¹⁴∼10¹⁹ cm⁻³ and its thickness is 1nm∼100nm.

Doping concentration of said high doped layer is far higher than concentration of the diffusion layer in traditional process, and can normally reach 10¹⁷∼10²¹cm⁻³, and its thickness is about a few thousands of Å.

Said metal layer can be common metal Al etc.

External back field voltage applied between upper and lower electrodes can be externally applied reverse bias voltage power supply between upper and lower electrodes.

The differences between structure of the present invention and that of traditional solar cells are very apparent, e.g.:
The present invention has an epitaxial layer of thickness of 15 µm∼20 µm, which functions in the device to increase capacity of the quantum well store, to ensure optimum output power. Such structure is absent in traditional solar cells; if epitaxial layer is provided in traditional solar cells, open circuit voltage will be higher and photovoltaic conversion rate will be lower. In contrast to that, the structure of the present invention provides an important prerequisite to increase conversion rate, hence a new structural characteristic.

In above scheme, special structure of solar cell and externally applied back field voltage power supply are key to increase of conversion efficiency. As long as back field voltage is kept at rated value and operating status is stable, the solar cell of quantum well store can maintain effective output power.

The present invention provides the following preferred embodiments:
1. Principle to provide reverse back field voltage for this solar cell of quantum well store is: said back field voltage is reverse bias voltage and internal resistance of this reverse bias voltage DC power supply is less than or equal to 1/N of load battery internal resistance. The N is not less than 3 and can be 3, 4 or 5 etc. (non-integral ratios are not excluded). In ideal state, the larger the N value, the better the effect is. Among them, numbers of actual industrial significance are 6 and higher. With progress in research of low internal resistance and even zero internal resistance batteries, ratio of back field voltage DC power supply to load battery internal resistance can approach infinitesimal. By using this type of low resistance battery as back field voltage DC power supply, conversion efficiency of this invention can be further increased.
2. To further increase out put power, said back field voltage is reverse bias voltage and may be higher than load battery voltage.
3. Further improvement of the improved scheme of above clause 2: said reverse bias voltage may always be higher than load battery voltage by about 2V.

The present invention recommends the following data: said back field voltage shall adopt 15V.

On traditional solar cells, application of 15V or higher back field voltage will cause breakdown; while in the present invention, this back field voltage is a favorable boundary condition for formation of quantum well.
4. Said strip shaped longitudinal ribs can be made to a number of parallel dikes. Width of each longitudinal rib is from a few microns to more than 10 microns. Distance between neighboring longitudinal ribs (i.e. width of between the ribs) is a few hundreds of microns. Each longitudinal rib and its nearby between the ribs constitute one strip unit. A number of strip units connected in sequence constitute main structure of this invention. At the same time, at least one transverse rib of the same structure shall penetrate all strip units so that all units are connected in parallel. After rib top metallization, comb like electrode structure is formed on front (negative pole) of cell.

To facilitate leading of wire, upper electrode connection wire can be provided on metal layer at top of transverse rib. Quantity of said transverse ribs can be 2.

At one side of semiconductor epitaxial layer, high doped electrode layer (extra-high doped poly-silicon crystal) can be provided and lower electrode connection wire is directly led from this high doped electrode layer.
5. Recommendations by this invention: Said epitaxial layer adopts thickness of **15-20** microns and resistivity of **7.5∼8.50**Ω**.cm;** said ion-implanted layer adopts thickness of 1∼100nan meters; and said high doped layer adopts thickness of sub-micron grade.
6. Where grid is available, for back field voltage power supply, battery can be replaced by a circuit comprising transformer and rectifier.
7. Between ion-implanted layer and high doped layer, and between ion-implanted layer and semiconductor base layer, a buffering intrinsic layer (π) can be provided.
8. By means of diffusion, isolating groove can be provided around said substrate.
9. To obtain high output current and reduce loss, said semiconductor substrate adopts extra-high doped semiconductor material of resistivity less than **0.005**Ω**·cm.**

Above technical solution of this invention has a number of embodiments of realization, including various forms and techniques of existing technologies, e.g. provision of passivation layer, anti-reflection film, and grating electrode etc., which can all be the same as those of traditional solar cells.

In the above technical solution, when subject to light, output voltage at solar cell outlet is higher than back field voltage, so that back field voltage power supply cannot output current to load. Therefore, during operation, voltage of back field voltage power supply is basically stable.

In this invention, after adoption of the technical scheme in which ion-implanted layer, high doped layer, and epitaxial layer are added, and back field voltage is applied between semiconductor substrate and high doped layer, in particular selection of the boundary condition of small internal resistance ratio of back field voltage power supply, efficiency of the solar cell is greatly increased. Output current of traditional solar cells is **30mA,** but output current of the solar cell of quantum well store of this invention can reach **150mA.** Output voltage of traditional solar cells is 0.5V, but output voltage of this invention is about **15V** and can even reach 17V. Normally, output power of traditional solar cells is **0.02W/cm²,** but output power of the solar cell of this invention can reach **2W**/cm². Under ideal lab process conditions, this can reach **7W**/cm².

The large increase of efficiency by this invention is the result of actual tests and detections. The data far exceeds limit efficiency given by current theory of solar energy power generation. Solar cell built-in electric field and externally applied DC power supply electric field constitute a new electric field, which can expand existing space charge region by many times. After being subject to light, minority carriers excited by solar energy and majority carriers generated by thermoelectric conversion (including majority carriers generated by infrared light of sun and thermoelectric conversion using heat generated by sunshine, those generated by thermoelectric conversion using heat of surrounding environment) constitute majority carrier transmission mechanism. Under boundary conditions of this invention, disorderly movement of thermo-electrons is changed to orderly movement, generating current and greatly increasing conversion efficiency. Photovoltaic conversion efficiency in its traditional sense is no longer applicable to estimation of conversion efficiency of this cell, since in addition to photovoltaic conversion, this cell also mainly involves thermo-electric conversion. As ambient heat is difficult to measure, this cell cannot be represented by conversion efficiency, but only by measured power. Details of particular action mechanism needs further study.

Method to prepare solar cell of quantum well store according to the present invention comprises the following steps:
1. Substrate preparation: adopt n type or P type semiconductor material;
2. Growth of epitaxial layer: growth of n⁻ type or P⁻ type epitaxial layer;
3. Formation of diffusion zone: After oxidation on epitaxial layer and first photo-etching of predetermined between the ribs, p⁺ type or n⁺ type diffusion zone is formed by diffusion;
4. Formation of ion-implanted layer: Grow a layer of silicon dioxide and then carry out second photo-etching: etch windows at positions of ribs reserved among said diffusion zones (to completely remove oxide layer in window zones); inject or diffuse compound of group 3 or group 5 element, and then carry out annealing so that impurity is pushed to required depth, to form p⁺ type or n⁺ type ion-implanted layer;
5. Formation of high doped layer: On ion-implanted layer, grow another layer of silicon dioxide and then carry out third photo-etching to obtain windows for growth of poly-silicon; carry out fourth photo-etching to remove oxide layer on poly-silicon and obtain diffusion windows. Use method of ion implantation to inject or diffuse compound of group 3 or group 5 element, or use method of LPCVD to form high doped layer;
6. Metal contact and interconnection: Carry out aluminum evaporation on surface of high doped layer to form aluminum film. Carry out fifth photo-etching to form interconnecting metal electrodes;
7. Rear encapsulation process;
8. Connect back field voltage power supply between electrodes.

The last step of above method needs not be carried out during production stage and can be carried out when using the cell.

As further improvement of above method of preparation, the following preferred embodiments are provided:
1. Substrate adopts high doped semiconductor material, e.g. n⁺⁺ type or P⁺⁺ type silicon of resistivity less than 0.005Ω·cm;
2. In said step of growth of epitaxial layer, thickness of this layer prepared is **15∼20** microns and its resistivity is 7.5-8.5Ω·cm;
3. In said processing steps, photo-etching process conditions are: temperature controlled in 30∼50°C and duration is 3∼5 min;
4. In said diffusion step, process conditions are: temperature controlled in 1000∼1200°C and duration is 16-20min;
5. In said ion layer formation step, process conditions are: Inject compound of group 3 or group 5 element under 50kV; temperature controlled at 1000°C, duration is about 3 hours, and concentration is 10¹⁴∼10¹⁹cm⁻³; thickness controlled in 1nm-100nm and width is a few microns to some tens of microns;
6. In said step of high doped layer formation, conditions for adoption of in-situ doping process are: temperature controlled in 550-650°C, vacuum controlled at 10⁻⁵torr, thermal insulation duration of 3 hours, thickness of arsenic doped poly-silicon grown controlled at about 1 micron, concentration of **10¹⁷∼10²¹cm⁻³,** and width of a few microns to a few tens of microns;
7. In metal interconnecting step, conditions for aluminum evaporation process on surfaces of high doped implanted zone are: temperature of 1148 °C, substrate temperature of 250°C, temperature maintained constant for 8∼12min, to generate surface evaporated aluminum layer on high doped layer;
8. In the step of connection of back field voltage power supply, the voltage is reverse bias voltage applied between electrodes, so that device reverse bias voltage is 0.1∼3V. If the load is battery, DC power supply internal resistance is less than or equal to 1/N of that of battery, and optimum value of N is equal to or larger than 6.

This invention overcomes the shortcoming of too low output power per unit area of traditional solar cells. In addition to photovoltaic conversion, the solar cell of quantum well store of the new structure provided is better capable of full absorption of "thermal current carriers" to generate current, providing main current of the cell and resulting in an essential leap in conversion efficiency. Preparation process of this solar cell of quantum well store of the new structure provided by this invention is mature and can be used for large scale industrial production.

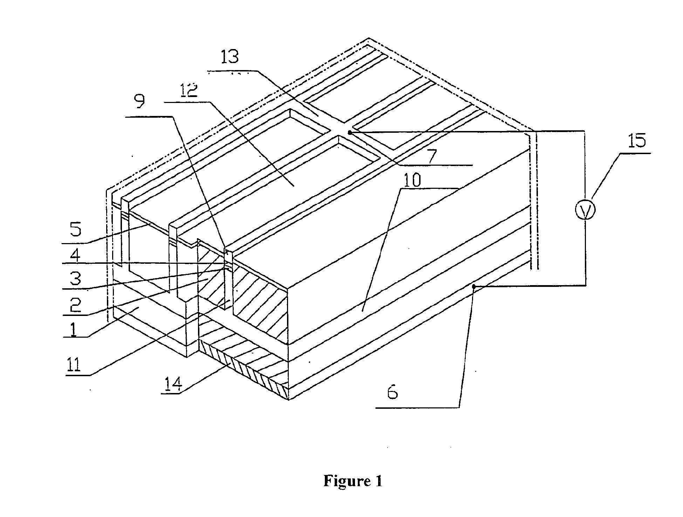

**Description of the drawings** Fig.1 is the structural schematic of a preferred embodiment 1 of this invention.

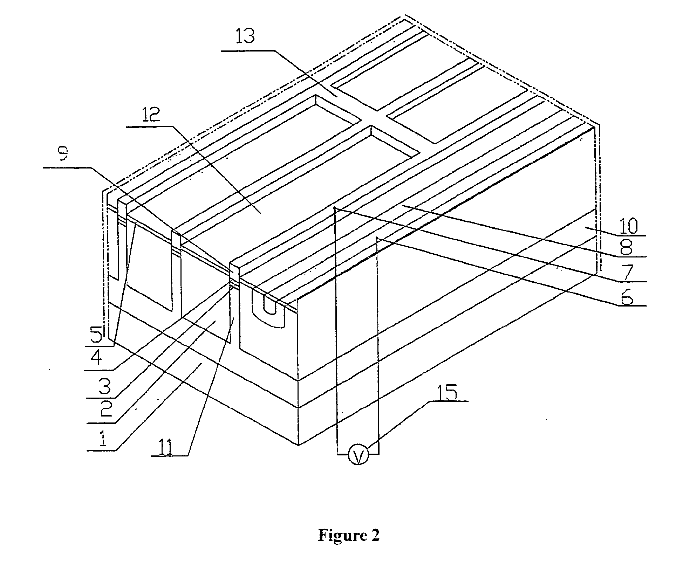

Fig.2 is the structural schematic of a preferred embodiment 2 of this invention.

### Preferred embodiments

In the preferred embodiment 1 of this invention, solar cell of quantum well store consists of solar cell board and back field voltage DC power supply connected in series. For its structure, refer to Fig.1: Metal electrode layer 14 is provided under extra-high doped n⁺⁺ type silicon substrate, and connected to lower electrode 6. On n⁺⁺ type silicon substrate 1, light doped n⁻ type silicon epitaxial layer 10 of thickness of **15∼20** microns. On this layer, a number of parallel longitudinal ribs 11 and two transverse rigs 13 are provided, and forming between the ribs 12 (surrounded by ribs 11 and 13); on longitudinal ribs 11, **p**⁺ type ion-implanted layer 3 and **n**⁺⁺ type high doped layer 4 are provided, and layer 4 covers layer 3. High doped layer 4 is covered by metal Al layer 9; upper electrode 7 is connected to metal Al layer 9 on top of transverse rib 13; inside between the ribs is **p**⁺ type diffusion laver 2, on which oxide layer 5 is provided; at the same time, between upper electrode 7 and lower electrode 6, external DC back field voltage power supply 15 is applied, with back field voltage of 15V and internal resistance less than or equal to 1/6 of load battery internal resistance.

Ion-implanted layer 3 is clamped between **n**⁻ type epitaxial layer 1 and **n**⁺⁺ type high doped layer 4, forming two (upper and lower) PN junctions and constituting a sandwich structure of **n**⁺⁺, **p**⁺, **n**⁻. p⁺ type ion-implanted layer 3 is covered by **n**⁺⁺ high doped layer 4 of thickness of 1nm∼100nm. As for the whole cell, n⁺⁺, p⁺ and n⁻ sandwich structure adopts rib arrangement. Width of each longitudinal rib 11 is a few microns to less than twenty microns. Between such ribs is a rectangular zone formed by **p**⁺ type diffusion layer 2, and distance between longitudinal ribs 11 (i.e. width of between the ribs) is a few hundred microns. Upper surface of diffusion layer 2 is covered by oxide layer 5; during operation, this is used to receive incident solar energy. Besides, ribs 11 and 13 formed by each **n**⁺⁺, **p**⁺, **n**⁻ sandwich structure are connected to metal Al layer 5. Electrodes 6 and 7 are led from metal electrode layer 14 and Al layer 5 on top of longitudinal rib 13.

Refer to Fig.2 for particular preparation process of solar cell of nanometer quantum well store of this embodiment. Steps are as follows:
1. Preparation of substrate: Extra-high doped **n**⁺⁺ type silicon semiconductor material is adopted. Its resistivity is less than 0.005Ω·cm; standard (100) crystal face is selected;
2. Growth of epitaxial layer: One layer of light doped **n**⁻ silicon is grown as epitaxial layer. Thickness of this epitaxial layer is **15∼20** microns and its resistivity is **7.5-8.5**Ω**·cm;**
3. Formation of diffusion layer: Apply about **5** portions of dry oxygen, plus **60** portions of wet oxygen, and then **5** portions of dry oxygen again. Oxidation temperature is controlled at **1100°C,** so that a layer of silicon dioxide is grown on surface of n⁻ type epitaxial layer **10.** Control temperature at **40°C** for **4**min, to remove oxide layer on diffusion zone by etching and form diffusion windows. Control temperature at **1100°C** for **18**min. to push in impurity to depth of micron level by means of boron diffusion on between the ribs 12 of n⁻ type silicon epitaxial layer, to form **p**⁺ diffusion layer 2;
4. Formation of ion-implanted layer: Apply wet oxygen for about **30**min and then **40** portions of dry oxygen, control temperature at **1050°C,** to grow a layer of silicon dioxide. Later, perform secondary photo-etching to remove oxide layer at positions of longitudinal ribs 11 and transverse ribs 13 between diffusion zones. Under **50**kV, inject BF₃; control temperature at **1000°C** for about 3 hours, control thickness in **1nm∼100nm** and concentration in **10¹⁴∼10¹⁹cm⁻³;** carry out annealing to form ion-implanted layer 3;
5. Formation of high doped layer: Carry out third photo-etching to create windows on surface of ion-implanted layer 3, remove oxide layer, and grow poly-silicon. Carry out fourth photo-etching, control temperature at 600°C and vacuum at 10⁻⁵torr, maintain temperature for 3 hours, control concentration at **10¹⁷∼10²¹cm⁻³.** Dope As in poly-silicon to form high doped layer 4;
6. Metal interconnection: Carry out fifth photo-etching, to create windows on high doped layer 4 and remove oxide layer. At temperature of **1148 °C** and substrate temperature of **250°C,** maintain temperatures for **10**min, and then evaporate Al layer 5 on upper surface of high doped layer 4, to form comb type electrode structure;
7. Connect upper electrode to evaporated Al layer on top of transverse rib. Later, carry out thinning, rear metallization, scribing, racking, and encapsulation;
8. Between electrodes, connect back field voltage power supply.

### Preferred embodiment 2

Main differences between preferred embodiment 1 and 2: In preferred embodiment 2, semiconductor substrate 1 is **p**⁺⁺ type, epitaxial layer is **p**⁻ type, diffusion laver 2 is **n**⁺ type, ion-implanted layer 3 is **n**⁺ type, and high doped layer 4 is **p**⁺⁺ type.

Besides, in preferred embodiment 2, high doped layer adopts doped poly-silicon, which can not only be used as doping diffusion source, but also as interconnection lead. High doped electrode layer 8 at one side of semiconductor epitaxial layer is directly used as lead-out electrode of lower electrode 6. In this way, not only leading-out of electrodes is easier, plane structure can be realized, and single crystal silicon can be used for manufacture, lowering the costs.

Differences in method of solar cell preparation of preferred embodiment 2 as compared with embodiment 1: In formation of diffusion layer, boron diffusion is replaced by phosphorus diffusion; in formation of ion-implanted layer, BF₃ ion injection is replaced by PF₃ ion injection; and in formation of high doped layer, growth of As doped poly-silicon is replaced by that of B doped poly-silicon.

In addition to above preferred embodiments, this invention can adopt other forms. For example, between high doped layer and ion-implanted layer, and between ion-implanted layer and substrate, intrinsic layer (π) can be provided as buffer. To reduce leak current, around substrate, provide **p**⁺ or **n**⁺ isolating groove can be provided by means of diffusion (reduce costs, such isolating groove can be omitted).

## Claims

1. A solar cell of quantum well store, comprising a semiconductor substrate, a diffusion layer and upper and lower electrodes, wherein a light doped epitaxial layer whose conductive type is the same as the semiconductor substrate is disposed on said semiconductor substrate, there are ribs on the epitaxial layer, the ribs are the structure of strip shape and comprise multiple longitudinal ribs which are parallel and at least one transverse rib, the transverse rib is connected with and run through parallel longitudinal ribs; an interspace surrounded by longitudinal ribs and transverse rib is a between the ribs; disposed on the ribs of strip shape: a nanometer ion-implanted layer which has opposite conductive type to that of epitaxial layer and a high doped layer which has opposite conductive type to that of ion-implanted layer, the nanometer ion-implanted layer is covered with the high doped layer, and the high doped layer is covered with a metal layer; the lead of upper electrode is connected to the metal layer on transverse rib; the diffusion layer is disposed in the whole between the ribs and its conductive type is opposite with that of epitaxial layer, an oxide layer is disposed on the diffusion layer; and, the voltage of back field is applied between the upper and lower electrodes.

2. The solar cell of quantum well store of claim 1, wherein said back field voltage is reverse bias voltage, the internal resistance of this reverse bias voltage DC power supply is less than or equal to 1/N of load battery internal resistance, and value of N is larger than 6.

3. The solar cell of quantum well store of claim 1, wherein said back field voltage is higher than load battery voltage.

4. The solar cell of quantum well store of claim 3, wherein said back field voltage is always higher than load battery voltage by about 2V.

5. The solar cell of quantum well store of claim 3, wherein said back field voltage adopts 15V.

6. The solar cell of quantum well store of claim 1, wherein said longitudinal ribs have a width from a few microns to less than 20 microns, and spacing of a few hundred microns.

7. The solar cell of quantum well store of claim 6, wherein 2 said transverse ribs are provided, and upper electrode is connected to metal layer on top of such transverse ribs.

8. The solar cell of quantum well store of claim 6, wherein at one side of semiconductor epitaxial layer, high doped electrode layer of extra-high doped poly-silicon material is disposed and lower electrode connection wire is directly led from this high doped electrode layer.

9. The solar cell of quantum well store of claim 1, wherein said epitaxial layer has thickness of 15∼20 nanometers and resistivity of 7.5-8.5Ω·cm; said ion-implanted layer has thickness of **1∼100** nanometers and doping concentration of **10¹⁴∼10¹⁹ cm⁻³;** and said high doped layer has sub-micron level thickness and doping concentration of 10¹⁷~10²¹cm⁻³.

10. The solar cell of quantum well store of claim 1, wherein back field voltage power supply is back field voltage power supply circuit comprising transformer and rectifier where grid is available.

11. The solar cell of quantum well store of claim 1, wherein said semiconductor substrate material adopts extra-high doped semiconductor material of resistivity less than **0.005**Ω**·cm.**

12. The solar cell of quantum well store of claim 1, wherein said semiconductor substrate is **n**⁺⁺ type silicon, said epitaxial layer is n⁻ type silicon, said diffusion layer is **p**⁺ type silicon, and said high doped layer is **n**⁺⁺ type extra-high doped poly-silicon.

13. The solar cell of quantum well store of claim 1, wherein said semiconductor substrate is **P**⁺⁺ type silicon, said epitaxial layer is **p**⁻ type silicon, said diffusion layer is **n**⁺ type silicon, and said high doped layer is **P**⁺⁺ type extra-high doped poly-silicon.

14. The solar cell of quantum well store of claims 1∼13, wherein on load circuit, a charging branch circuit is connected via a DC booster and to the back field power supply.

15. The solar cell of quantum well store of claims 1∼13, wherein isolation groove is provided around said substrate by means of diffusion.

16. The solar cell of quantum well store of claims 1∼13, wherein buffering intrinsic layer is provided between ion-implanted layer and high doped layer, and between ion-implanted layer and semiconductor base layer.

17. Preparation method for the solar cell of quantum well store of claim 1, comprising the following steps:
(1) Substrate preparation: adopt n type or P type semiconductor material;
(2) Growth of epitaxial layer: growth of n⁻ type or P⁻ type epitaxial layer;
(3) Formation of diffusion zone: After oxidation on epitaxial layer and first photo-etching of predetermined between the ribs, p⁺ type or n⁺ type diffusion zone is formed by diffusion;
(4) Formation of ion-implanted layer: Grow a layer of silicon dioxide and then carry out second photo-etching: etch windows at positions of ribs reserved among said diffusion zones (to completely remove oxide layer in window zones); inject or diffuse compound of group 3 or group 5 element, and then carry out annealing so that impurity is pushed to required depth, to form p⁺ type or n⁺ type ion-implanted layer;
(5) Formation of high doped layer: On ion-implanted layer, grow another layer of silicon dioxide and then carry out third photo-etching to obtain windows for growth of poly-silicon; carry out fourth photo-etching to remove oxide layer on poly-silicon and obtain diffusion windows. By injection or diffusion of compound of group 3 or group 5 element, use method of ion implantation or LPCVD to form extra-high doped layer;
(6) Metal contact and interconnection: Carry out fifth photo-etching and aluminum evaporation on surface of high doped layer to form aluminum layer and interconnecting metal electrodes;
(7) Rear encapsulation process;
(8) Connect back field voltage power supply between electrodes.

18. Preparation method for said solar cell of quantum well store of claim 17, wherein said semiconductor substrate adopts high doped semiconductor material of resistivity less than **0.005**Ω**·cm;**

19. Preparation method for said solar cell of quantum well store of claim 17, wherein in said process steps, thickness of epitaxial layer prepared is **10∼20** nanometers.

20. Preparation method for said solar cell of quantum well store of claim 17, wherein prepared ion-implanted layer has a thickness of **1∼100** nanometers and a concentration of **10¹⁴∼10¹⁹cm⁻³.**

21. Preparation method for said solar cell of quantum well store of claim 17, wherein high doped layer prepare has a doping concentration of **10¹⁷∼10²¹cm⁻³** and thickness of **0.7**µ**m-0.9**µ**m.**

22. Preparation method for said solar cell of quantum well store of one of claim 17∼21, wherein,
In said process steps, conditions for photo-etching process are: temperature controlled at **30∼50°C** and duration is **3∼5**min;
In said diffusion steps, process conditions are: temperature controlled at **1000~1200°C,** and duration is **16-20**min;
In said ion-implanted formation steps, process conditions are: compound of group 3 or group 5 element is implanted under **50**KV, temperature controlled at 1000°C, and duration is about **3** hours;
In said high doped layer formation steps, conditions for adoption of in-situ doping process are: temperature controlled at **550-6500°C,** vacuum controlled at **10⁻⁵,** and duration is 3 hours;
In said metal contact and interconnection steps, conditions for surface evaporated Al layer process on high doped implanted zone are: temperature at **1148°C,** substrate temperature at **250°C,** temperatures are maintained for **8-12**min to form surface evaporated Al layer on high doped layer;
In step of connection of back field voltage power supply, back field voltage applied between the electrodes is 1~3V; and its internal resistance is less than or equal to 1/6 of internal resistance of external load battery.

23. Preparation method for said solar cell of quantum well store of claim 22, wherein in said diffusion layer formation step, temperature is controlled at **1100°C** for **18**min, and by means of boron diffusion on diffusion zone of **n**⁻ type silicon semiconductor epitaxial material, **p**⁺ type diffusion layer is formed.

24. Preparation method for said solar cell of quantum well store of claim 22, wherein in said diffusion layer formation step, temperature is controlled at **1100°C** for **18**min, and type n⁺ diffusion layer is formed by phosphorus diffusion on diffusion zone of **p**⁻ type silicon semiconductor epitaxial material.

25. Preparation method for said solar cell of quantum well store of claim 22, wherein in said ion-implanted layer formation step, said compound of group 3 or group 5 element is BF₃.

26. Preparation method for said solar cell of quantum well store of claim 22, wherein in said ion-implanted layer formation step, said compound of group 3 or group 5 element is PF₃.

27. Preparation method for said solar cell of quantum well store of claim 22, wherein in said high doped layer formation step, said extra-high doped poly-silicon is extra-high As doped poly-silicon.

28. Preparation method for said solar cell of quantum well store of claim 22, wherein in said high doped layer formation step, said extra-high doped poly-silicon is extra-high B doped poly-silicon.
